(19) Europäisches Patentamt
European Patent Office
Office européen des brevets

(11) **EP 3 797 919 A2**

(12) **EUROPÄISCHE PATENTANMELDUNG**

(43) Veröffentlichungstag:
**31.03.2021 Patentblatt 2021/13**

(51) Int Cl.:
***B23K 26/14*** *(2014.01)*

(21) Anmeldenummer: **20190244.2**

(22) Anmeldetag: **10.08.2020**

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**
Benannte Validierungsstaaten:
**KH MA MD TN**

(30) Priorität: **30.09.2019 DE 102019215000**

(71) Anmelder: **Robert Bosch GmbH
70442 Stuttgart (DE)**

(72) Erfinder:
• **Bormann, Axel
96049 Bamberg (DE)**
• **Heider, Andreas
70565 Stuttgart (DE)**
• **Alter, Lukas
70193 Stuttgart (DE)**
• **Proell, Johannes
96052 Bamberg (DE)**
• **Kunz, Gerhard
71272 Renningen (DE)**

(54) **MIKROSCHWEISSVERFAHREN FLEXIBLER UND DÜNNER FOLIEN, BSPW. FÜR DEN EINSATZ IN ELEKTRISCHEN UND ELEKTRONISCHEN VORRICHTUNGEN**

(57) Die Erfindung betrifft ein Verfahren zum Schweißen einer flexiblen Folie (10) mit einer Trägerkomponente (20), aufweisend folgende Schritte:
1) Andrücken der Folie (10) auf der Trägerkomponente (20) durch einen Volumenstrom eines Fluids,
2) Laserschweißen der Folie (10) auf der Trägerkomponente (20).

Fig. 3

EP 3 797 919 A2

**Beschreibung**

Die Erfindung betrifft ein Verfahren zum Schweißen einer flexiblen Folie mit einer Trägerkomponente.

Stand der Technik

Bei dünnen, bspw. metallischen, Folien ist für den Fügevorgang mit einer, bspw. ebenfalls metallischen, Trägerkomponente die Spanntechnik entscheidend, um einen technischen Nullspalt zu gewährleisten. Ein technischer Nullspalt ist deswegen wichtig, da mit einem Spalt kein Wärmeübertrag und keine Erzeugung einer Schweißnaht erfolgen und/oder die Folien ungewollt durchtrennt werden können.

Offenbarung der Erfindung

Die Erfindung sieht ein Verfahren zum Schweißen einer flexiblen Folie mit einer Trägerkomponente mit den Merkmalen des unabhängigen Verfahrensanspruches vor. Weitere Vorteile, Merkmale und Details der Erfindung ergeben sich aus den Unteransprüchen, der Beschreibung und den Zeichnungen. Dabei gelten Merkmale und Details, die im Zusammenhang mit unterschiedlichen Ansprüchen einer Ausführungsform der Erfindung beschrieben sind, selbstverständlich auch im Zusammenhang mit anderen Ansprüchen derselben Ausführungsform und jeweils umgekehrt, sodass bezüglich der Offenbarung zu den einzelnen Erfindungsaspekten stets wechselseitig Bezug genommen wird bzw. werden kann.

Die vorliegende Erfindung sieht ein Verfahren zum Schweißen (Fügen bzw. stoffschlüssiges Verbinden) einer flexiblen Folie mit einer Trägerkomponente, aufweisend folgende Schritte:

1) Andrücken der Folie auf der Trägerkomponente durch einen Volumenstrom eines Fluids,
2) Laserschweißen der Folie auf der Trägerkomponente.

Das erfindungsgemäße Verfahren kann zum Schweißen flexibler und dünner Folien mit einer Schichtdicke im Mikrometerbereich verwendet werden. Mit anderen Worten kann das erfindungsgemäße Verfahren als ein Mikroschweißverfahren bezeichnet werden. Als Laserschweißen im Sinne der Erfindung kann vorzugsweise ein Wärmeleitungsschweißen oder ein Schweißprozess nahe der Tiefschweißschwelle der zu verbindenden Elementen (Folien und Trägerkomponenten) verwendet werden.

Unter Andrücken im Sinne der Erfindung wird ein Niederhalten der Folie auf der Trägerkomponente mithilfe einer berührungslosen Spanntechnik verstanden, um einen Nullspalt zwischen der Folie und der Trägerkomponente, insbesondere im Bereich einer gewünschten Schweißnaht, zu erreichen.

Zum Andrücken wird im Sinne der Erfindung ein Volumenstrom eines unter Druck stehenden Fluids verwendet, vorzugsweise in Form von Druckluft, Stickstoff, Schutzgas (Ar, He, CO2,...), etc.

Als eine flexible Folie im Sinne der Erfindung kann eine dünne Folie aus Metall, bspw. Kupfer, oder Kunststoff mit einer Schichtdicke im Mikrometerbereich, insbesondere zwischen 20 $\mu$m - 100 $\mu$m, vorzugsweise 35 $\mu$m, verstanden werden. Als eine flexible Folie im Sinne der Erfindung kann bspw. eine innerhalb einer flexiblen Leiterplatte, sog. flexible-printed circuit oder kurz FPC, eingebettete flexible Leiterbahn verstanden werden.

Als eine Trägerkomponente im Sinne der Erfindung kann eine Trägerkomponente aus Metall, bspw. Kupfer, oder Kunststoff mit einer Schichtdicke im Mikrometerbereich, insbesondere zwischen 50 $\mu$m - 500 $\mu$m, vorzugsweise zwischen 50 $\mu$m - 140 $\mu$m, bevorzugt 135 $\mu$m, verstanden werden. Als eine Trägerkomponente im Sinne der Erfindung kann bspw. eine elektrische Trägerkomponente, z. B. in Form eines Landings, auf einer, bspw. starren, Platine, sog. printed-circuit board oder kurz PCB.

Die Erfindung stellt ein neuartiges Schweißverfahren zur Verbindung dünner, bspw. metallischer, Folien mit, bspw. ebenfalls dünnen, Trägermaterialien bereit. Der Erfindungsgedanke liegt dabei darin, dass ein Volumenstrom eines, vorzugsweise unter Druck stehenden Fluids, verwendet wird, um eine berührungslose Spanntechnik zum Niederhalten der Folie auf der Trägerkomponente zu realisieren. Dadurch kann bei einem anschließenden Schweißen ein verlustarmer Wärmeübertrag zwischen der Folie und der Trägerkomponente zur Erzeugung einer Schweißnaht ermöglicht werden. Weiterhin ermöglicht der Volumenstrom einen nahezu technischen Nullspalt. Auch wird dadurch sichergestellt, dass die Folie, sei es aufgrund des Spalts und/oder zu hoher Lasereinstrahlung, nicht ungewollt durchtrennt wird. Die vorgeschlagene berührungslose Spanntechnik eliminiert oder zumindest vermindert zudem den Schweißprozess störenden Metalldampf.

Das erfindungsgemäße Verfahren kann grundsätzlich zur Kontaktierung dünner metallischer Leiterbahnen mit elektronischen Vorrichtungen jeglicher Art verwendet werden. Das erfindungsgemäße Verfahren kann bspw. zur Kontaktierung von Leiterbrücken in mikrogedruckten Bauelementen verwendet werden, wie z.B. beim Aufbau von MEMS-Vorrichtungen, bspw. durch Vereinigung eines Laser-Induced-Forward-Transfer-Verfahrens (LIFT) mit dem erfindungsgemäßen Mikroschweißverfahren. Das erfindungsgemäße Verfahren kann weiterhin in Batterie-Management-Systemen (bspw. in Lithium-Ionen-Batterien) verwendet werden, speziell zum Kontaktieren dünner metallischer Flachleiter mit Platinen (z. B. für einen Spannungsabgriff, bspw. bei einer Zellspannungsüberwachung). Das erfindungsgemäße Verfahren kann zudem zur Kontaktierung von dünnen Stromträgerfolien oder -platten mit Terminals von Batteriezellen (z.B. Rundzellen, bspw. in Lithium-Ionen-Batterien) verwendet werden.

Es ist ebenso denkbar, das erfindungsgemäße Verfahren mittels des Einsatzes einer Laserstrahlung mit einer geringen Strahlqualität (z.B. mithilfe eines Diodenlasers) auf die Anbindung von nichtmetallischen Folien (z.B. aus Kunststoff) an metallischen oder nichtmetallischen Trägermaterialien zu erweitern (z.B. für Verpackungsindustrie, Medizintechnik, Sensoren, etc.).

Ferner kann die Erfindung bei einem Verfahren zum Schweißen einer flexiblen Folie mit einer Trägerkomponente vorsehen, dass im Schritt 1) das Fluid in Form eines unter Druck stehenden Fluids, vorzugsweise in Form von Druckluft, Stickstoff, Schutzgas (Ar, He, CO2,...), etc. verwendet wird. Auf diese Weise kann nicht nur das Niederhalten der Folie auf der Trägerkomponente realisiert werden, sondern auch eine Vorbereitung für das nachfolgende Laserschweißen getroffen werden. Denkbar ist ferner, dass das Schutzgas das Laserschweißen erst ermöglichen oder zumindest erleichtern kann.

Weiterhin kann die Erfindung bei einem Verfahren zum Schweißen einer flexiblen Folie mit einer Trägerkomponente vorsehen, dass im Schritt 1) der Volumenstrom durch eine Düse oder einen Düsenkamm erzeugt wird. Mithilfe einer Düse kann der Volumenstrom beschleunigt und somit ein geeigneter Druck zum Niederhalten der Folie auf der Trägerkomponente eingestellt werden. Mithilfe eines Düsenkamms können mehrere Folien zugleich auf korrespondierenden Trägerkomponenten, bspw. auf einer Platine, angedrückt werden.

Des Weiteren kann die Erfindung bei einem Verfahren zum Schweißen einer flexiblen Folie mit einer Trägerkomponente vorsehen, dass im Schritt 2) eine Laserstrahlung im sichtbaren Wellenlängenbereich, vorzugsweise im grünen Wellenlängenbereich (von ca. 490 nm - 560 nm) und/oder im blauen Wellenlängenbereich (von ca. 380 nm - 480 nm) oder eine NIR-Laserstrahlung verwendet wird. Die Laserstrahlung im grünen Wellenlängenbereich und zum Teil im blauen Wellenlängenbereich hat sich als vorteilhaft erwiesen, um ein Wärmeleitungsschweißen von zu verbindenden Elementen (Folien und Trägerkomponenten) aus Kupfer zu ermöglichen, sogar unverzinnt. Eine NIR-Laserstrahlung kann einen Schweißprozess nahe der Tiefschweißschwelle der zu verbindenden Elemente ermöglichen. Somit kann ein Fügen bzw. Verbinden der Elemente am Umriss der Schweißnaht ermöglicht werden.

Zudem kann die Erfindung bei einem Verfahren zum Schweißen einer flexiblen Folie mit einer Trägerkomponente vorsehen, dass im Schritt 2) eine gepulste Laserstrahlung, eine Quasi-CW-Laserstrahlung oder eine CW-Laserstrahlung verwendet wird. Eine gepulste Laserstrahlung kann innerhalb der Pulse eine Spitzenleistung bereitstellen. Die gepulste Laserstrahlung kann beim Verwenden einer NIR-Laserstrahlung vorteilhaft sein, um eine ausreichende Haftung zwischen den Elementen entlang der Umrisse von mehreren, bspw. punktuellen, Schweißpunkten zu ermöglichen. Eine Quasi-CW-Laserstrahlung kann neben einem schmalen Spektrum ein Aufbringen von Spitzenleistungen ermöglichen. Eine Quasi-CW-Laserstrahlung kann beim Verwenden von grüner sowie blauer Laserstrahlung von Vorteil sein. Eine CW-Laserstrahlung kann eine präzise Einstellung der Einschweißtiefe ermöglichen.

Außerdem kann die Erfindung bei einem Verfahren zum Schweißen einer flexiblen Folie mit einer Trägerkomponente vorsehen, dass im Schritt 2) ein 2D-Galvoscanner, ein 1D-/2D-Polygonscanner oder ein Diodenlaser zur Erzeugung einer Laserstrahlung verwendet wird. Der 2D-Galvoscanner sowie der 1D-/2D-Polygonscanner können vorteilhaft sein, um die Schweißnaht zu erstellen und außerdem zu untersuchen bzw. zu scannen. Ein Diodenlaser kann vorteilhaft sein, um eine Laserstrahlung mit einer geringen Strahlqualität bereitzustellen, die zum Schweißen von nichtmetallischen Folien (z.B. aus Kunststoff) mit metallischen oder nicht metallischen Trägerkomponenten bspw. in Verpackungsindustrie, Medizintechnik oder Sensorik, vorteilhaft sein kann.

Ferner kann die Erfindung bei einem Verfahren zum Schweißen einer flexiblen Folie mit einer Trägerkomponente vorsehen, dass im Schritt 2) eine Schweißnaht mit einer einstellbaren Tiefe erzeugt wird. Durch die einstellbare Tiefe kann das erfindungsgemäße Verfahren an unterschiedlich dicke Folien flexibel angepasst werden. In manchen Fällen kann durch die einstellbare Tiefe sogar auf eine Hilfsbeschichtung, bspw. Verzinnung, von zu verbindenden Elementen verzichtet werden. Insbesondere kann dadurch die Wärmeleitung so eingestellt werden, dass das Material der Trägerkomponente im Bereich der gewünschten Schweißnaht ausreichend aufgewärmt wird, um eine stoffschlüssige Verbindung mit der Folie herzustellen, ohne jedoch die Folie zu beschädigen oder sogar abzureißen.

Weiterhin kann die Erfindung bei einem Verfahren zum Schweißen einer flexiblen Folie mit einer Trägerkomponente vorsehen, dass im Schritt 2) ein Wärmeleitungsschweißen oder ein Prozess nahe einer Tiefschweißschwelle für die Trägerkomponente verwendet wird. Auf diese Weise kann das erfindungsgemäße Verfahren möglichst zuverlässig ein Schweißen von dünnen metallischen Elementen ermöglichen und zugleich die dünnen zu verbindenden Elemente schonend bearbeiten. Zudem spritzt es bei einem Wärmeleitungsschweißen nicht, was bei Elektronikkomponenten vorteilhaft ist.

Des Weiteren kann die Erfindung bei einem Verfahren zum Schweißen einer flexiblen Folie mit einer Trägerkomponente vorsehen, dass im Schritt 2) eine Laserstrahlung, insbesondere eine Quasi-CW-Laserstrahlung, mit mindestens einem der folgenden Parameter verwendet wird:

- einer Wellenlänge von 500 nm - 600 nm, insbesondere 515 nm,
- einem Fokusdurchmesser von 20 $\mu$m - 1 mm, insbesondere 150 $\mu$m,
- einer Leistung von 1 W - 4000 W, insbesondere 200 W - 600 W,
- einer Pulsdauer von 0,3 ms - 50 ms, insbesondere 2 ms - 6 ms,
- einer Scangeschwindigkeit: 1 mm/s - 1 km/s, insbesondere 200 mm/s - 300 mm/s.

Leiterbahnen werden zumeist aus Kupfer hergestellt. Unter Verwendung einer solchen, vorzugsweise grüner, Laserstrahlung erhöht sich der Absorptionsgrad in Elementen (Folien und Trägerkomponenten) aus Kupfer um mind. 35% im Gegensatz zur Bearbeitung von Kupfer mit klassischen Laserstrahlquellen, bspw. im nahen Infrarotbereich. Durch den Einsatz einer solchen Laserstrahlung wird somit Wärmeleitungsschweißen von Elementen aus Kupfer ermöglicht, bspw. mithilfe einer grünen Quasi-CW-Laserstrahlung, sogar ohne eine Hilfsbeschichtung aus Zinn. Auf diese Weise wird daher ein erfindungsgemäßes Mikroschweißen von dünnen Elementen aus Kupfer ermöglicht.

Zudem ist es denkbar, dass im Schritt 2) eine kreisförmige Schweißnaht, vorzugsweise mit einem Durchmesser von 0,1 mm - 10 mm, insbesondere 0,1 mm - 0,4 mm, oder eine linienförmige Schweißnaht erzeugt wird. Außerdem ist es denkbar, dass im Schritt 2) eine Schweißnaht mit einer Länge von 0,1 mm - 5 mm, insbesondere 0,5 mm, erzeugt wird. Durch eine solche Schweißnaht kann eine schonende aber auch zuverlässige Anbindung der Folie an der Trägerkomponente ermöglicht werden.

Ferner kann die Erfindung bei einem Verfahren zum Schweißen einer flexiblen Folie mit einer Trägerkomponente vorsehen, dass im Schritt 2) eine Laserstrahlung, insbesondere eine gepulste Laserstrahlung, mit mindestens einem der folgenden Parameter verwendet wird:

- einer Wellenlänge von 1030 nm - 1064 nm,
- einem Fokusdurchmesser von 10 $\mu$m - 500 $\mu$m, speziell 20 $\mu$m - 200 $\mu$m,
- einer Leistung von 1 W - 2000 W, insbesondere 10 W - 500 W, vorzugsweise 20 W - 100 W,
- einer Frequenz von 1 Hz - 2000 kHz, insbesondere 1000 Hz - 2000 Hz,
- Pulsdauer: 1 ns - 500 ns, insbesondere 120 ns - 500 ns,
- einer Scangeschwindigkeit: 1 mm/s - 1 km/s, speziell 10 mm/s - 1000 mm/s, speziell 10 mm/s - 100 mm/s,

und/oder dass im Schritt 2) eine linienförmige Schweißnaht oder mehrere, insbesondere parallele, linienförmige Schweißnähte, erzeugt wird/werden, und/oder dass im Schritt 2) eine Schweißnaht mit einer Länge von 0,1 mm - 5 mm, insbesondere 0,4 mm, erzeugt wird.

Unter Verwendung einer solchen, vorzugsweise NIR-, bspw. gepulster, Laserstrahlung wird ein Schweißen von Elementen aus Kupfer am Rande einer Schweißnaht ermöglicht.

Weiterhin kann die Erfindung bei einem Verfahren zum Schweißen einer flexiblen Folie mit einer Trägerkomponente vorsehen, dass vor dem Schritt 1) ein Vorverformen der Folie, insbesondere in Form einer innerhalb einer flexiblen Leiterplatte eingebetteten flexiblen Leiterbahn, erfolgt. Dadurch kann das Niederhalten der Folie auf der Trägerkomponente zur Herstellung eines Nullspalts zwischen der Folie und der Trägerkomponente erleichtert werden. Auch die Treffsicherheit und Zielgenauigkeit beim Herstellen der Schweißnaht werden dadurch verbessert.

Des Weiteren kann die Erfindung bei einem Verfahren zum Schweißen einer flexiblen Folie mit einer Trägerkomponente vorsehen, dass nach dem Schritt 2) eine Prüfung, insbesondere eine optische Prüfung, einer Schweißnaht (N) auf Leitfähigkeit, Widerstand und/oder Impedanz erfolgt, wobei insbesondere in Abhängigkeit der Prüfung ein Nachschweißen erfolgen kann. Auf diese Weise kann die Ausschussquote eines fertigen Produktes deutlich reduziert werden.

Zudem kann die Erfindung vorsehen, dass das Verfahren zum Schweißen mehrerer flexiblen Folien mit mehreren Trägerkomponenten im gleichen Durchlauf verwendet wird. Somit können mehrere Funktionskomponenten zugleich an korrespondierenden Trägerkomponenten, bspw. auf einer Platine, angebunden werden.

Außerdem ist es denkbar, dass das Verfahren zum Schweißen einer flexiblen Folie aus Metall, insbesondere Kupfer, oder Kunststoff mit einer Trägerkomponente aus Metall, insbesondere Kupfer, oder Kunststoff verwendet wird. Auf diese Weise kann das Einsatzgebiet des erfindungsgemäßen Verfahrens vorteilhafterweise erweitert werden.

Im Rahmen der Erfindung ist es zudem denkbar, dass das Verfahren zum Schweißen dünner metallischer Leiterbahnen mit elektrischen Trägerkomponenten, bspw. in Form von Landings auf Platinen, in elektronischen Vorrichtungen, mikrogedruckten Bauelementen, Sensorvorrichtungen, elektrochemischen Energiewandlern, insbesondere Batterien oder Brennstoffzellen, verwendet werden kann.

Vorteilhafterweise kann das Verfahren zum Schweißen einer flexiblen Folie in Form einer innerhalb einer flexiblen Leiterplatte eingebetteten flexiblen Leiterbahn mit einer elektrischen Trägerkomponente in Form eines Landings auf einer starren Leiterplatte verwendet werden. Insbesondere kann das Verfahren zum Schweißen einer flexiblen Folie (10) einer Schichtdicke von 20 $\mu$m - 100 $\mu$m, insbesondere 35 $\mu$m, mit einer elektrischen Trägerkomponente (20) einer

Dicke von 50 μm - 500 μm, bspw. 50 μm - 140 μm, insbesondere 135 μm, verwendet werden.

Die vorliegende Erfindung sieht des Weiteren die Verwendung eines Energiesystems in einer mobilen Umgebung, bspw. in einem Fahrzeug, oder in einer stationären Umgebung, bspw. in einer Generatoranlage, vor.

Bevorzugte Ausführungsbeispiele:

Die Erfindung und deren Weiterbildungen sowie deren Vorteile werden nachfolgend anhand von Zeichnungen näher erläutert. Es zeigen jeweils schematisch:

Fig. 1    eine beispielhafte Darstellung der zu verbindenden Elementen im Sinne der Erfindung,

Fig. 2    eine beispielhafte Darstellung eines ersten Verfahrensschrittes im Sinne der Erfindung,

Fig. 3    eine beispielhafte Darstellung eines zweiten Verfahrensschrittes im Sinne der Erfindung,

Fig. 4    eine beispielhafte Darstellung eines optionalen vorbereitenden Verfahrensschrittes im Sinne der Erfindung,

Fig. 5    eine beispielhafte Darstellung einer elastischen Folie im Sinne der Erfindung,

Fig. 6    eine beispielhafte Darstellung einer Trägerkomponente im Sinne der Erfindung,

Fig. 7    ein Absorptions-Diagramm einer Laserstrahlung für Kupfer,

Fig. 8    ein Beispiel einer Schweißnaht im Sinne der Erfindung, und

Fig. 9    ein weiteres Beispiel einer Schweißnaht im Sinne der Erfindung.

In den unterschiedlichen Figuren sind gleiche Teile der Erfindung stets mit denselben Bezugszeichen versehen, weshalb diese in der Regel nur einmal beschrieben werden.

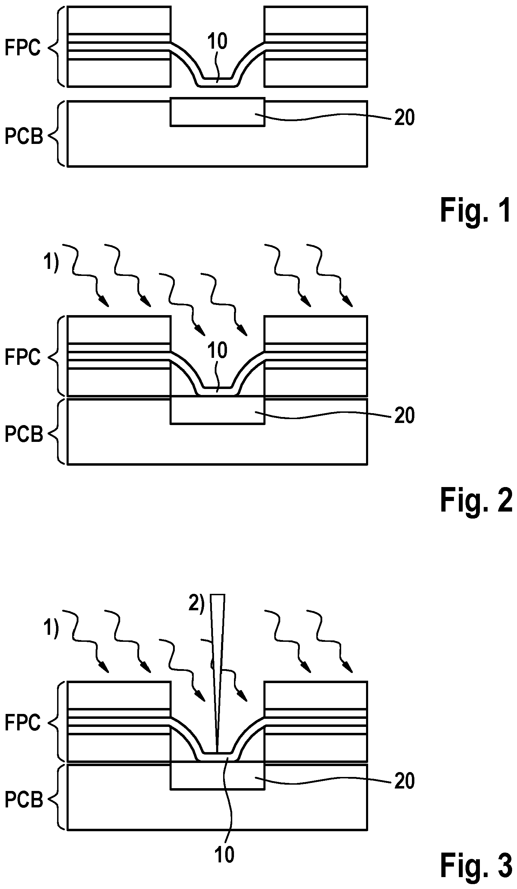

Die Figuren 1 bis 4 sollen dazu dienen, ein erfindungsgemäßes Verfahren zum Schweißen einer flexiblen Folie 10 mit einer Trägerkomponente 20 zu veranschaulichen. Die Figuren 1 bis 4 zeigen einen prinzipiellen Aufbau zum Durchführen des erfindungsgemäßen Verfahrens.

Die Figuren 1 bis 4 zeigen eine mögliche Folie 10 im Sinne der Erfindung, die in Form einer innerhalb einer flexiblen Leiterplatte (flexible-printed circuit oder kurz FPC) eingebetteten flexiblen Leiterbahn ausgeführt sein kann.

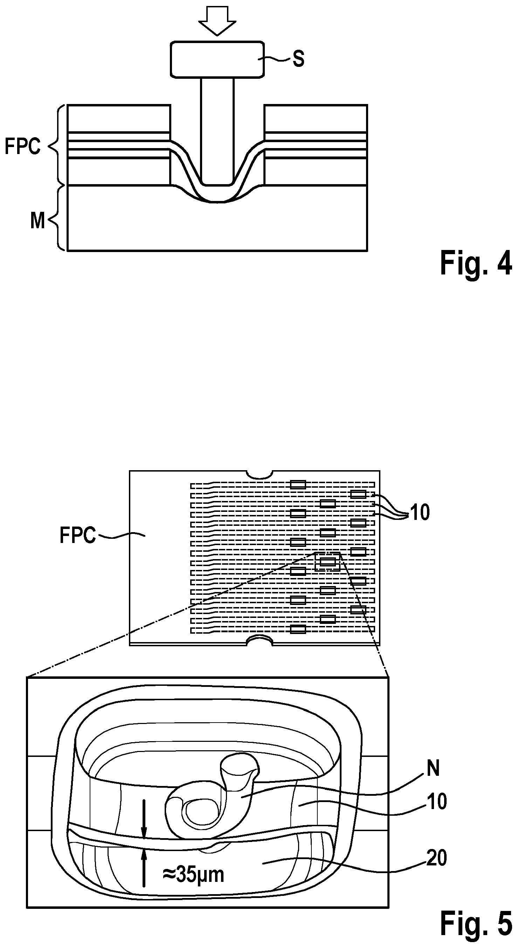

Die Figur 5 zeigt im Nachfolgenden eine flexible Leiterplatte FPC mit mehreren eingebetteten flexiblen Leiterbahnen als mögliche flexible Folien 10 im Sinne der Erfindung. Dabei kann jede flexible Leiterbahn aus Kupfer Cu ausgebildet sein und eine Stärke bzw. Schichtdicke von 20 μm - 100 μm, insbesondere 35 μm, aufweisen. Die Oberflächen der ausgesparten flexiblen Leiterbahnen können chemisch verzinnt oder unverzinnt ausgeführt sein. Gemäß der Figur 5 kann die flexible Leiterplatte FPC folgenden Aufbau aufweisen:

| | |
|---|---|
| Basisfolie | 25μm, Polyamid; |
| Klebstoff | 28μm; |
| Signallayer | 35/70μm Cu, chem. Sn; |
| Klebstoff | 60μm; |
| Deckfolie | 25μm, Polyamid. |

Ferner zeigen die Figuren 1 bis 4 eine mögliche Trägerkomponente 20 in Form einer elektrischen Trägerkomponente 20, insbesondere in Form eines Landings auf einer starren Leiterplatte (printed-circuit board oder kurz PCB).

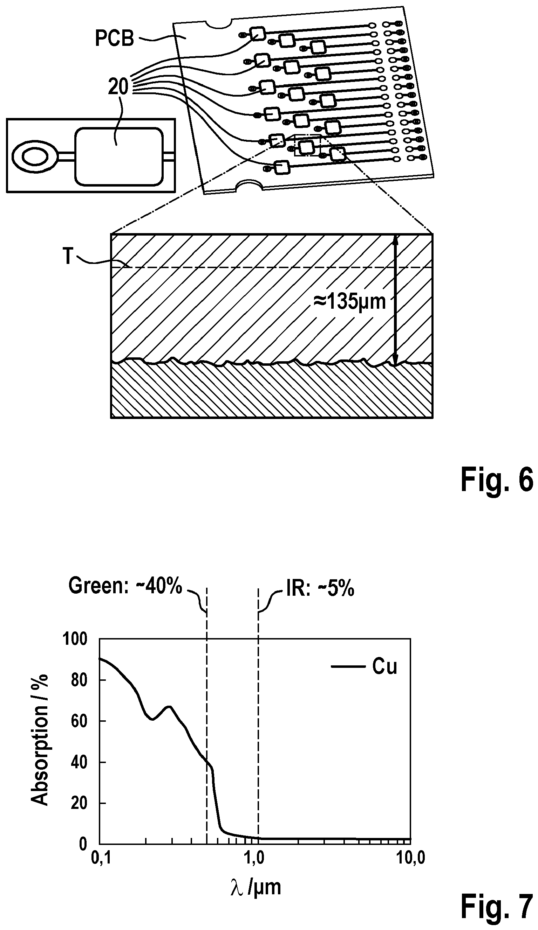

Die Figur 6 zeigt im Nachfolgenden mehrere elektrische Trägerkomponenten 20 in Form von mehreren Landings auf einer starren Leiterplatte PCB. Die Trägerkomponenten 20 (sog. Landings) können Stärken von 50 μm - 500 μm, bspw. 50 μm - 140 μm, insbesondere 135 μm, aufweisen. Davon können ca. 30 μm - 120 μm auf die Cu-Basisschicht selbst und jeweils ca. 20 μm auf eine aufgalvanisierte Cu-Schicht entfallen (siehe exemplarisch gestrichelte Trennlinie T in der unteren Schnittdarstellung der Figur 6). Die Landing-Oberfläche kann chemisch verzinnt sein, kann aber auch unverzinnt ausgeführt sein.

Denkbar ist es jedoch, dass das erfindungsgemäße Verfahren zur Kontaktierung dünner metallischer Leiterbahnen mit elektronischer Vorrichtungen jeglicher Art verwendet werden kann, wie z. B. mikrogedruckten Bauelementen, Sensorvorrichtungen, elektrochemischen Energiewandlern, insbesondere Batterien oder Brennstoffzellen.

Die Figur 2 zeigt den ersten Schritt des erfindungsgemäßen Verfahrens:

1) Andrücken der Folie 10 auf der Trägerkomponente 20 durch einen Volumenstrom eines Fluids.
Als Fluid kann dabei ein unter Druck stehendes Fluid, vorzugsweise in Form von Druckluft, Stickstoff oder Schutzgas (Ar, He, CO2,...), etc. verwendet werden.
Die Figur 3 zeigt den zweiten Schritt des erfindungsgemäßen Verfahrens:
2) Laserschweißen der Folie 10 auf der Trägerkomponente 20.

Als Laserschweißen im Sinne der Erfindung kann bspw. ein Wärmeleitungsschweißen oder ein Schweißprozess nahe der Tiefschweißschwelle der zu verbindenden Elemente 10, 20 (Folien 10 und Trägerkomponenten 20) verwendet werden.

Die Figur 4 zeigt ferner, dass vor dem Schritt 1) ein, insbesondere wannenförmiges, Vorverformen der Folie 10 durch einen Prägestempel S und eine Negativ-Form M zur gezielten Überdehnung der Folie 10 durchgeführt werden kann, bspw. mithilfe von Mikroverformen und/oder Tiefziehen.

Die Figur 7 zeigt mithilfe eines Diagramms die Absorptionsrate von Laserstrahlung unterschiedlicher Wellenlängen in Kupfer Cu, insbesondere für grüne Laserstrahlung und für NIR-Laserstrahlung. Aus der Figur 7 ist es ersichtlich, dass unter Verwendung grüner Laserstrahlung sich der Absorptionsgrad in Kupfer Cu um 35% im Gegensatz zur Bearbeitung von Kupfer Cu mit klassischen Laserstrahlquellen im nahen Infrarotbereich NIR erhöht. Durch den Einsatz von grüner Laserstrahlung wird das Mikroschweißen von Cu-Verbindungen also möglich.

Die grüne Laserstrahlung, insbesondere in Form von Quasi-CW-Laserstrahlung, die im Schritt 2) des erfindungsgemäßen Verfahrens verwendet wird, kann mindestens einen der folgenden Parameter und/oder Eigenschaften aufweisen:

- Wellenlänge: 500 nm - 600 nm, speziell 515 nm,
- Fokusdurchmesser: 20 $\mu$m - 1mm, speziell 150 $\mu$m,
- Fokuslage: z = 0 mm bis zu z = +/- 2 zR, speziell z = +/- 1 zR,
- Leistung: 1 W - 4000 W, speziell 200 W - 600 W,
- Pulsdauer: 0,3 ms - 50 ms, speziell 2 ms - 6 ms,
- Pulsform: Rechteck, Rampe(n),
- Scangeschwindigkeit: 1 mm/s - 1 km/s, speziell 200 mm/s - 300 mm/s,
- Scannertechnik: 2D-Galvoscanner, 1D-/2D-Polygonscanner,
- Länge der Schweißnaht 0,1 mm - 5 mm, speziell 0,5 mm,
- Geometrie der Schweißnaht: Kreis mit einem Durchmesser von 0,1 mm - 10 mm, speziell 0,1 mm - 0,4 mm oder Linie mit einer Länge von 0,1 mm - 5 mm Länge, speziell 0,5 mm.

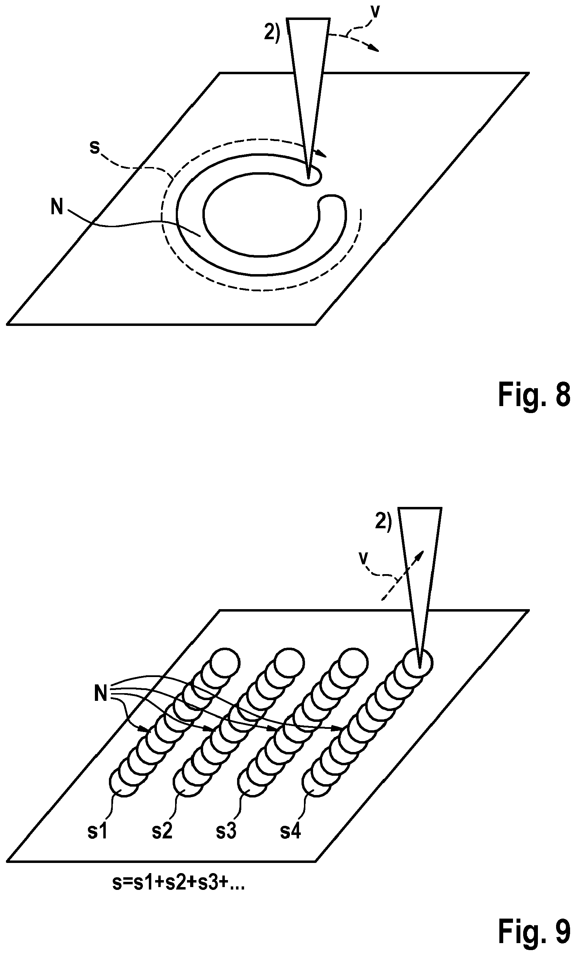

Die Figur 8 zeigt eine kreisförmige Schweißnaht, die mithilfe der grünen Laserstrahlung, insbesondere in Form von Quasi-CW-Laserstrahlung, erzeugt werden kann. Der Schweißprozess zwischen der flexiblen Leiterplatte FPC auf einer starren Leiterplatte PCB gemäß der Figur 8 kann innerhalb eines Laserpulses durchgeführt werden. Dieser Laserpuls kann im Rahmen der Erfindung eine Dauer von ca. 2 ms - 5 ms aufweisen. In dieser Zeit wird der Laserstrahl in Form eines Kreises oder in Form von Linien über die Oberfläche der flexiblen Leiterplatte FPC auf einer starren Leiterplatte PCB geführt (sog. long pulse welding oder quasi cw welding). Somit entstehen während eines Pulses ringförmige oder linienförmige Mikroschweißnähte mit der Nahtlänge s. Die Schweißnahttiefe kann vorteilhafterweise über die sog. Streckenenergie L (Quotient aus Laserleistung & Verfahrgeschwindigkeit) gesteuert werden.

$$L = \frac{\text{Leistung } P}{\text{Geschwindigkeit } v} \left[ \frac{\text{Ws}}{\text{m}} = \frac{\text{J}}{\text{m}} \right]$$

In einem gewissen Prozessregime (abhängig von Cu-/Sn-Schichtdicken der flexiblen Leiterplatten FPCs und der starren Leiterplatten PCBs) steigt bei konstanter Bearbeitungsgeschwindigkeit und Laserfokusfläche die Einschweißtiefe mit zunehmender Laserleistung an, ohne dass die zu verbindenden Elemente 10, 20 beschädigt werden.

Die Figur 9 zeigt mehrere linienförmige Schweißnähte, die mithilfe der NIR-Laserstrahlung, insbesondere in Form von gepulster Laserstrahlung, erzeugt werden können. Unter Verwendung gepulster NIR-Laserstrahlung kann trotz niedrigem Absorptionsgrad Energie/Wärme im Material deponiert werden, da die gepulste NIR-Laserstrahlung einen kleinen Fokusdurchmesser aufweist und daraus resultierende hohe Intensität einen Tiefschweißeffekt hervorruft. Durch den Einsatz gepulster NIR-Laserstrahlung wird das Mikroschweißen im Sinne der Erfindung von Cu-Verbindungen also ebenfalls ermöglicht.

Die NIR-Laserstrahlung, insbesondere in Form von gepulster Laserstrahlung, die im Schritt 2) des erfindungsgemäßen Verfahrens verwendet wird, kann mindestens einen der folgenden Parameter und/oder Eigenschaften aufweisen:

- Laserfokusdurchmesser 10 $\mu$m - 500 $\mu$m, speziell 20 $\mu$m - 200 $\mu$m,
- Wellenlänge: 1030 nm - 1064 nm;
- Leistung: 1 W - 2000 W, speziell 10 W - 500 W, speziell 20 W - 100 W;
- Rep. Rate: 1 Hz - 2000 kHz, speziell 1000 Hz - 2000 Hz;
- Pulsdauer: 1 ns - 500 ns, speziell 120 ns - 500 ns;
- Geometrie: Linien (0,4 mm Länge, 100 $\mu$m hatch, andere denkbar);
- Scangeschwindigkeit: 1 mm/s - 1 km/s, speziell 10 mm/s - 1000 mm/s, speziell 10 mm/s - 100 mm/s;
- Scannertechnik: 2D-Galvoscanner, 1D-/2D-Polygonscanner.

Der Schweißprozess zwischen der flexiblen Leiterplatte FPC auf einer starren Leiterplatte PCB gemäß der Figur 9 kann mittels einer Vielzahl an Laserpulsen durchgeführt werden. Ein einzelner Laserpuls kann dabei eine typische Dauer von ca. 120 ns aufweisen (ggf. längere Pulse bis 500 ns denkbar). Innerhalb der Schweißzeit wird der Laserstrahl in Form von Linien über die Oberfläche der flexiblen Leiterplatte FPC auf einer starren Leiterplatte PCB geführt. Somit entstehen mehrere linienförmige Mikroschweißnähte mit der Nahtlänge s, bestehend aus einer Vielzahl an Pulsen. Der für den Schweißprozess benötigte Wärmeeintrag in das Material kann durch sog. Wärmeakkumulation einzelner Laserpulse gesteuert werden, wodurch sich eine mittlere Erwärmung $\Delta T$ ergibt.

$$\Delta T = (1 - R) \cdot \frac{2 \cdot I_0}{\lambda} \cdot \nu_{rep} \cdot \tau \cdot \sqrt{\alpha \cdot t} \cdot \mathrm{ierfc}\left(\underbrace{\frac{z}{\sqrt{4 \cdot \alpha \cdot t}}}_{\boxed{\frac{1}{\sqrt{\pi}} \text{ für } z = 0}}\right)$$

Im Zentrum des Laserstrahls wird das Material verdampft, entlang der Mantelfläche des Abtrages bildet sich die Schweißnaht aus. Dabei kann Zinn Sn schmelzen und in dünnen Randzonen auch Kupfer Cu.

Darüber hinaus ist es denkbar, dass das erfindungsgemäße Verfahren mittels des Einsatzes einer Laserstrahlung mit einer geringen Strahlqualität (z.B. mithilfe eines Diodenlasers) auf die Anbindung von nichtmetallischen Folien (z.B. aus Kunststoff) an metallischen oder nichtmetallischen Trägermaterialien erweitert werden kann (z.B. für Verpackungsindustrie, Medizintechnik, Sensoren, etc.).

Die voranstehende Beschreibung der Figuren beschreibt die vorliegende Erfindung ausschließlich im Rahmen von Beispielen. Selbstverständlich können einzelne Merkmale der Ausführungsformen, sofern es technisch sinnvoll ist, frei miteinander kombiniert werden, ohne den Rahmen der Erfindung zu verlassen.

**Patentansprüche**

1. Verfahren zum Schweißen einer flexiblen Folie (10) mit einer Trägerkomponente (20), aufweisend folgende Schritte:

   1) Andrücken der Folie (10) auf der Trägerkomponente (20) durch einen Volumenstrom eines Fluids,
   2) Laserschweißen der Folie (10) auf der Trägerkomponente (20).

2. Verfahren nach Anspruch 1,
   **dadurch gekennzeichnet,**
   **dass** im Schritt 1) das Fluid in Form eines unter Druck stehenden Fluids, vorzugsweise in Form von Druckluft, Stickstoff und/oder Schutzgas verwendet wird,
   und/oder dass im Schritt 1) der Volumenstrom durch eine Düse oder einen Düsenkamm erzeugt wird.

3. Verfahren nach Anspruch 1 oder 2,
   **dadurch gekennzeichnet,**

**dass** im Schritt 2) eine Laserstrahlung im sichtbaren Wellenlängenbereich, vorzugsweise im grünen Wellenlängenbereich und/oder im blauen Wellenlängenbereich oder eine NIR-Laserstrahlung verwendet wird, und/oder dass im Schritt 2) eine gepulste Laserstrahlung, eine Quasi-CW-Laserstrahlung oder eine CW-Laserstrahlung verwendet wird.

4. Verfahren nach einem der vorhergehenden Ansprüche,
**dadurch gekennzeichnet,**
**dass** im Schritt 2) eine Laserstrahlung, insbesondere eine Quasi-CW-Laserstrahlung, mit mindestens einem der folgenden Parameter verwendet wird:

- einer Wellenlänge von 500 nm - 600 nm, insbesondere 515 nm,
- einem Fokusdurchmesser von 20 $\mu$m - 1 mm, insbesondere 150 $\mu$m,
- einer Leistung von 1 W - 4000 W, insbesondere 200 W - 600 W,
- einer Pulsdauer von 0,3 ms - 50 ms, insbesondere 2 ms - 6 ms,
- einer Scangeschwindigkeit: 1 mm/s - 1 km/s, insbesondere 200 mm/s - 300 mm/s.

5. Verfahren nach einem der vorhergehenden Ansprüche 1 bis 3,
**dadurch gekennzeichnet,**
**dass** im Schritt 2) eine Laserstrahlung, insbesondere eine gepulste Laserstrahlung, mit mindestens einem der folgenden Parameter verwendet wird:

- einer Wellenlänge von 1030 nm - 1064 nm,
- einem Fokusdurchmesser von 10 $\mu$m - 500 $\mu$m, speziell 20 $\mu$m - 200 $\mu$m,
- einer Leistung von 1 W - 2000 W, insbesondere 10 W - 500 W, vorzugsweise 20 W - 100 W,
- einer Frequenz von 1 Hz - 2000 kHz, insbesondere 1000 Hz - 2000 Hz,
- Pulsdauer: 1 ns - 500 ns, insbesondere 120 ns - 500 ns,
- einer Scangeschwindigkeit: 1 mm/s - 1 km/s, speziell 10 mm/s - 1000 mm/s, speziell 10 mm/s - 100 mm/s.

6. Verfahren nach einem der vorhergehenden Ansprüche,
**dadurch gekennzeichnet,**
**dass** vor dem Schritt 1) ein Vorverformen der Folie (10) erfolgt.

7. Verfahren nach einem der vorhergehenden Ansprüche,
**dadurch gekennzeichnet,**
**dass** nach dem Schritt 2) eine Prüfung einer Schweißnaht (N) auf Leitfähigkeit, Widerstand und/oder Impedanz erfolgt.

8. Verfahren nach einem der vorhergehenden Ansprüche,
**dadurch gekennzeichnet,**
**dass** das Verfahren zum Schweißen mehrerer flexiblen Folien (10) mit mehreren Trägerkomponenten (20) im gleichen Durchlauf verwendet wird, und/oder dass das Verfahren zum Schweißen einer flexiblen Folie (10) aus Metall, insbesondere Kupfer, oder Kunststoff mit einer Trägerkomponente (20) aus Metall, insbesondere Kupfer, oder Kunststoff verwendet wird.

9. Verfahren nach einem der vorhergehenden Ansprüche,
**dadurch gekennzeichnet,**
**dass** das Verfahren zum Schweißen dünner metallischer Leiterbahnen mit elektrischen Trägerkomponenten in elektronischen Vorrichtungen, mikrogedruckten Bauelementen, Sensorvorrichtungen, elektrochemischen Energiewandlern, insbesondere Batterien oder Brennstoffzellen, verwendet wird.

10. Verfahren nach einem der vorhergehenden Ansprüche,
**dadurch gekennzeichnet,**
**dass** das Verfahren zum Schweißen einer flexiblen Folie (10) in Form einer innerhalb einer flexiblen Leiterplatte (FPC) eingebetteten flexiblen Leiterbahn mit einer elektrischen Trägerkomponente (20) in Form eines Landings auf einer starren Leiterplatte (PCB) verwendet wird, und/oder dass das Verfahren zum Schweißen einer flexiblen Folie (10) einer Schichtdicke von 20 $\mu$m - 100 $\mu$m, insbesondere 35 $\mu$m, mit einer elektrischen Trägerkomponente (20) einer Dicke von 50 $\mu$m - 500 $\mu$m, insbesondere 50 $\mu$m - 140 $\mu$m, bevorzugt 135 $\mu$m, verwendet wird.

**Fig. 1**

**Fig. 2**

**Fig. 3**

FPC

M

S

**Fig. 4**

FPC

10

N

10

20

≈35µm

**Fig. 5**

**Fig. 6**

**Fig. 7**

Fig. 8

$$s = s1 + s2 + s3 + \ldots$$

Fig. 9